# EUROPEAN PATENT APPLICATION

(11) **EP 4 538 609 A1**
(43) Date of publication of application: **16.04.2025**
(21) Application number: 23202866.2
(22) Date of filing: 11.10.2023
(51) Int. Cl.: F24F 11/89, F24F 13/20, H05K 9/00

(54) **ELECTRICALLY CONDUCTIVE AND AIR-TIGHT LAYER FOR HEAT PUMP SYSTEMS**

(71) Applicant: BDR Thermea Group B.V., 7332 BD Apeldoorn (NL)
(72) Inventor: FONT, Antoni, 7332 BD Apeldoorn (NL); GUZMAN, Miquel, 7332 BD Apeldoorn (NL)
(74) Representative: Dennemeyer & Associates S.A.

(57) **Abstract**

The present invention relates to a heat pump system with a seal that is both electrically conductive and air-tight. The sealing material comprises a closed-cell foam with a conductive material woven into it. Such a heat pump system meets the Electromagnetic Compatibility (EMC) requirements and also efficiently prevents refrigerant leakages from potentially reaching ignition sources.

## Description

The present invention relates to a heat pump system with a seal that is both electrically conductive and air-tight. The sealing material comprises a conductive material. Such a heat pump system meets the Electromagnetic Compatibility (EMC) requirements and also efficiently prevents refrigerant leakages from potentially reaching ignition sources.

Heat pumps, especially those using flammable refrigerants, demand an air-tight seal to preclude the potential of these refrigerants, such as from leakage, from contacting any ignition sources either within or outside the heat pump system. This is particularly crucial for certain parts of the heat pump, most notably the electrical box. Additionally, these systems must adhere to Electromagnetic Compatibility (EMC) requirements to shield electronic components from external electromagnetic interferences and to ensure that the systems components do not interfere with the external environment. Traditional heat pump systems employ steel sheets would fail to meet the necessary EMC requirements when simply using a non-conductive sealing solution without the use of specific assembly means such as screwing or welding the parts together.

Due to machine costs, investment, and time it is preferred to make an electrical box for a heat pump with an external housing wherein the external housing is made of several metal panels bent instead of a one-piece, stamped, metal box. Usually, the electrical box is made of at least two parts thus leading to at least one junction that needs to be sealed. Depending on the material used, for example unpainted galvanized sheet metal, there can be no welding for air-tightness as the welding would break the galvanized effect which introduces a risk of corrosion of the welded section. Also, the inside of the electrical box needs to be reachable in case of installation or maintenance so the box cannot be fully welded for air-tightness for this reason also. Simply attaching the multiple sheets with screws, rivets or the like does not guarantee any good sealing.

Those kind of components must be air-tight enough that a flammable refrigerant, like an A3 class refrigerant such as propane, cannot enter components such as the electrical box. By regulation, the concentration of an A3 class refrigerant may not exceed 25% of the lower flammability limit (LFL) inside such a component. A proper sealing along any junction between metal plates is necessary. This is typically done by means of a non-conductive seal such as an open-cell, synthetic rubber-based, elastomer foam layer, having a resistance of around 100 Ohm or above between the upper surface and lower surface of the layer, said surfaces are its contact surfaces with the metal plates. An example of such a layer would be the use of Armaflex.

Beside the air-tightness, the heat pump and its components need to comply with electromagnetic compatibility requirements and standards. This means that any electrical element needs to be shielded to prevent a certain amount of electromagnetic radiation to be emitted from the heat pump to the environment of the heat pump.

Additionally, for safety reasons when dealing with electronics, it is compulsory that each element made of an electrically conductive material that could potentially come into contact with an electrical wire should be connected to earth. Meaning, all metal panel must be electrically connected to earth, either directly or indirectly via a wire attached to another panel for example. Obviously, the use of a regular non-conducting sealing along a junction between metal plates will disrupt the connectivity between the metal plates and thus disrupting the connection to earth. Therefore, it is an object of the invention to have a heat pump wherein any air-tight seal or layer is also electrically conductive.

The object of the invention is achieved by providing a heat pump system comprising an electrical conductive housing and a sealing layer positioned between components of the electrical conductive housing wherein the sealing layer is both electrically conductive and air-tight.

The electrical conductive housing may be a metallic housing or a plastic housing with a conductive coating applied onto it. The components of the housing are parts or elements of the housing such as the panels that, assembled together, form the housing.

The sealing layer acts as an interface between two electric conductive parts of the housing, such as steel, which effectively creates a protective shield against electromagnetic interference while ensuring an air-tight seal to prevent passage of any potentially leaked flammable refrigerant. This will therefore also result in an air-tight assembly of the metallic housing preventing any refrigerant from escaping the metallic housing. Air-tight thus also means refrigerant-tight. As such, the electronic box of the heat pump passes the refrigerant leak simulation test according to appendix FF of IEC 60335-2-40.

The sealing layer preferably has a sufficient degree of elasticity to compensate the gap between any components of the metallic housing, such as a gap between two metal sheets or panels. When the sealing layer is installed, a compression of at least 60% is preferred to reach a desired degree of sealing.

In an embodiment, the sealing layer has an electrical resistance between its upper surface and its lower surface of less than 10 Ohm, preferably less than 1 Ohm, more preferably less than 0.5 Ohm, and wherein the sealing layer comprises an electrically conductive material. In other words, the sealing layer may have an electrical resistance between its upper surface and its lower surface of less than 10 Ohm measured for instance with a ohmmeter, preferably less than 1 Ohm, more preferably less than 0.5 Ohm. This electrical resistance is achieved by means of the conductive material present in the sealing layer. The conductive material creates a conductive path between the upper and lower surface and may for example be included in the sealing layer as a powder or a fiber. The sealing layer may be made of an open-cell foam such as polyurethane or made of a closed-cell foam such as polyethylene. The sealing layer may be an elastomer, i.e. a polymer material with elastic properties such as Neoprene. The sealing layer may be a combination of any of the aforementioned materials. Alternatively, the sealing layer may be a conductive glue. The sealing layer may be made as a one-part element or made of several layers. When using an elastomer for the sealing layer, the sealing layer typically is a one-part element. When using a foam, typically the sealing layer is made of several layers with a deformable layer in the center and two surface layers wherein the surface layers may be adhesive.

In an embodiment, the sealing layer comprises a closed-cell foam, an elastomer, or a combination of both, and wherein the sealing layer comprises at least one conductive material selected from the group of copper, nickel, gold, aluminum, silver, or a combination thereof. The sealing layer may comprise a closed-cell foam such as EPDM, an elastomer such as Neoprene or a combination of both such as a EPDM-Neoprene multi-part sealing layer. The conductive material may be present in the form of a powder, like a powder mesh, or a fiber. Alternatively, the conductive material may be a conductive insert. The sealing layer thus, for example, may be a EPDM-Neoprene closed-cell foam and elastomer combination with a copper braid, fiber, material integrated into the layer. The copper braid may, for instance, be inserted on each side of said layer. In this case, the copper threads create a bridge between the upper and lower surface of the sealing layer, offering a desired conductivity path. This particular example has the advantage that the electrical resistance between the upper and lower surface of the sealing layer, is less than 0,5 Ohm thus providing a sufficient air-tight seal while also passing EMC requirements.

In an embodiment, the sealing layer, when uncompressed, has a thickness between 1 and 10 mm, preferably between 4 and 8 mm, more preferably a thickness equal to 6 mm. The thickness is the thickness before any deformation, thus before putting the sealing layer under any kind of pressure upon assembling any of the metal sheets or plates of the heat pump system. Within the range of 1 and 10 mm of thickness, the gap between two metal sheets or panels can be properly closed to create an air-tight seal.

In an embodiment, the heat pump system comprises an electronic box wherein the sealing layer is fixed between at least one junction of two or more electrically conductive sheets of the housing of the electronic box. The electrically conductive sheets may be metal sheets. The aforementioned sealing layer is especially beneficial towards application at the electronic box as the electronic box typically comprises one or more electronics that can act as an ignition source for any leaked refrigerant and also emit any electromagnetic radiation towards the outside of the electronic box and outside the heat pump system.

In an embodiment, the heat pump system comprises an electronic box wherein the sealing layer is fixed between at least one junction of two or more metal sheets of the housing of the electronic box. While the sealing layer can be beneficial to any part of, and within, the heat pump system, the sealing layer is especially beneficial for a separate electronic box positioned within the heat pump system to separate and shield any electronics from the rest of the heat pump system.

In an embodiment, the sealing layer fixed of the electronic box has a surface area of at least 500 mm2 and/or a length of at least 15 mm.

In an embodiment, the electromagnetic radiation emissions of the electronic box is below 40 dB at 100 MHz according to EN61000-6-2.

In an embodiment, the electromagnetic radiation emissions of the electronic box is below 30-37dB from 30MHz to 1GHz according to EN55014-1.

In an embodiment, the electronic box of the heat pump system comprises an electronic source able to ignite a flammable refrigerant and the heat pump system further comprises a refrigerant loop using a flammable refrigerant. The electronic box may thus comprise an electronic component that could get hot or could create a spark which may ignite a flammable refrigerant if a flammable refrigerant potentially could leak from a refrigerant loop.

In an aspect of the invention, a method for manufacturing an electronic box for a heat pump system is provided, comprising the steps of placing a sealing layer comprising conductive material within a closed-cell foam, an elastomer or a combination of a closed-cell foam and an elastomer on an edge of a first metal sheet and adjoining a second metal sheet to the first metal sheet on the sealing layer thereby creating an electrically conductive and air-tight seal between the first and second metal sheet.

In another aspect of the invention, a sealing layer of a heat pump system is provided comprising an elastomer foam material and a conductive material integrated into the elastomer foam.

In an embodiment, the foam material is EPDM, the elastomer is Neoprene and the conductive material is copper braiding integrated into the EPDM-Neoprene mixture.

In an embodiment, copper braiding crosses the EPDM-Neoprene mixture between its upper surface and its lower surface.

In the figures, the subject-matter of the invention is schematically shown, wherein identical or similarly acting elements are usually provided with the same reference signs.
- Fig. 1: shows a schematic representation of a heat pump system according to an invention.
- Fig. 2: shows a schematic representation of an electrical box according to an aspect of the invention.
- Fig. 3A: shows a schematic representation of a sealing layer according to an aspect of the invention.
- Fig. 3B: shows another schematic representation of a sealing layer according to an invention.

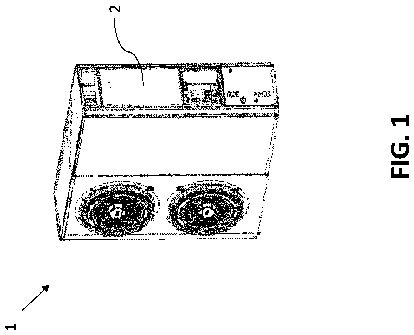

Figure 1 shows an external view of a heat pump system 1 where the front panel of the heat pump housing is removed and the electrical box 2 is visible.

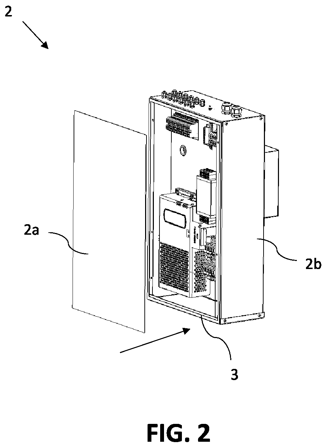

In Figure 2, an electrical box 2 is shown wherein the electrical box 2 is partially assembled as shown by assembly 2b. A front cover 2a of the electrical box 2 is about to be attached to assembly 2b. A sealing layer 3 is present along the edges of the assembly 2b and upon attachment of the front cover 2a the sealing layer 3 will be compressed and resulting in an electrically conducting and air-tight seal.

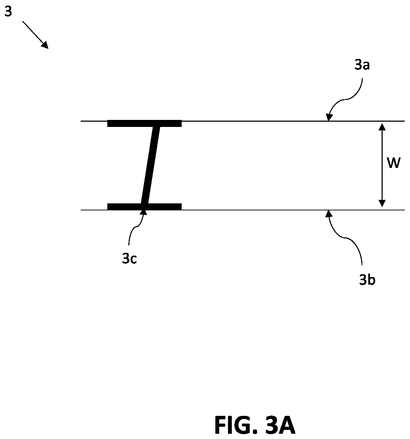

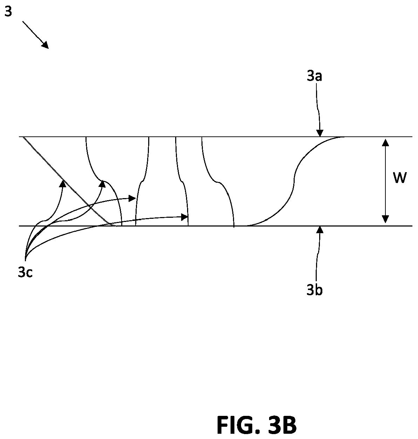

Figures 3A and 3B both show examples of a sealing layer 3. In both figures an upper surface 3a and a lower surface 3b can be seen. Between these, a conductive material 3c is present. In case of Figure 3A, an electrically conductive insert is provided that may compress when the sealing layer 3 is compressed as a whole. In case of Figure 3B, multiple strands of electrically conductive fibers are included into the sealing layer 3 that create multiple conductive paths between the upper surface 3a and the lower surface 3b of the sealing layer 3.

### Reference Signs

- 1: heat pump system
- 2: electrical box
- 2a: front panel of electrical box
- 2b: partially assembled electrical box
- 3: conductive seal
- 3a: upper surface of seal
- 3b: lower surface of seal
- 3c: electrically conductive material

## Claims

1. A heat pump system (1) comprising:
- a electrical conductive housing; and
- a sealing layer (3) positioned between components of the electrical conductive housing; wherein the sealing layer (3) is both electrically conductive and air-tight.

2. The heat pump system (1) according to claim 1, wherein the sealing layer (3) has an electrical resistance of less than 10 Ohm between its upper surface (3a) and its lower surface (3b), preferably less than 1 Ohm, more preferably less than 0.5 Ohm, and wherein the sealing layer (3) comprises a electrically conductive material (3c).

3. The heat pump system (1) according to claim 1 or 2, wherein the sealing layer (3) comprises a closed-cell foam, an elastomer, or a combination of both, and wherein the sealing layer (3) comprises at least one conductive material (3c) selected from the group of copper, nickel, gold, aluminum, silver, or a combination thereof.

4. The heat pump system (1) according to any of the preceding claims, wherein the sealing layer (3), when uncompressed, has a thickness between 1 and 10 mm, preferably between 4 and 8 mm, more preferably a thickness equal to 6 mm.

5. The heat pump system (1) according to any of the preceding claims, wherein the heat pump system (1) comprises an electronic box (2) wherein the sealing layer (3) is fixed between at least one junction of two or more electrically conductive sheets of the housing of the electronic box (2).

6. The heat pump system (1) according to claim 5, wherein the sealing layer (3) has a surface area of at least 500 mm2 and/or a length of at least 15 mm.

7. The heat pump system (1) according to claims 5 or 6, wherein the electromagnetic radiation emissions of the electronic box (2) is below 40 dB at 100 MHz according to EN61000-6-2.

8. The heat pump system (1) according to claims 5 or 6, wherein the electromagnetic radiation emissions of the electronic box (2) is below 30-37dB from 30MHz to 1GHz according to EN55014-1.

9. The heat pump system (1) according to claims 5 to 8, wherein the electronic box (2) is at least IP54 according to EN 60529.

10. The heat pump system (1) according to any of the preceding claims, wherein the electronic box (2) comprises an electronic source able to ignite a flammable refrigerant and wherein the heat pump system (1) further comprises a refrigerant loop using a flammable refrigerant.

11. A method for manufacturing an electronic box (2) for a heat pump system (1), comprising the steps of:
- placing a sealing layer (3) comprising conductive material within a closed-cell foam, an elastomer or a combination of a closed-cell foam and an elastomer on an edge of a first metal sheet;
- adjoining a second metal sheet to the first metal sheet on the sealing layer (3) thereby creating an electrically conductive and air-tight seal between the first and second metal sheet.

12. A sealing layer (3) of a heat pump system, comprising:
- an elastomer foam; and
- a conductive material (3c) integrated into the elastomer foam.

13. The sealing layer (3) according to claim 12, wherein the foam material is EPDM, the elastomer is Neoprene and the conductive material is copper braiding integrated into the EPDM-Neoprene mixture.

14. The sealing layer (3) according to claim 13, wherein the copper braiding crosses the EPDM-Neoprene mixture between its upper surface (3a) and its lower surface (3b).
